(19) Europäisches Patentamt
European Patent Office
Office européen des brevets

(11) **EP 0 701 155 A2**

(12) **EUROPÄISCHE PATENTANMELDUNG**

(43) Veröffentlichungstag:
13.03.1996 Patentblatt 1996/11

(51) Int. Cl.⁶: **G02B 6/42**, G02F 1/09

(21) Anmeldenummer: 95112292.8

(22) Anmeldetag: 04.08.1995

(84) Benannte Vertragsstaaten:
**DE ES FR GB IT SE**

(30) Priorität: **02.09.1994 DE 4431285**

(71) Anmelder: **ANT Nachrichtentechnik GmbH**
**D-71522 Backnang (DE)**

(72) Erfinder:
• **Kuke, Albrecht, Dr.**
**D-71549 Auenwald (DE)**
• **Möss, Eberhard**
**D-71540 Murrhardt (DE)**

(54) **Lasermodul**

(57) Ein Lasermodul dient zur Ankopplung eines Halbleiterlasers an einen Lichtwellenleiter, insbesondere eine Einmodenfaser. Bekannte Lasermodule weisen eine Zweilinsen-Koppeloptik und einen Isolator im Strahlengang auf. Der Halbleiterlaser ist beispielsweise auf einem Chipträger montiert.

Es wird ein Lasermodul angegeben, das besonders einfach, ohne viele Justageschritte, hergestellt werden kann. Das Lasermodul weist eine Silizium-Trägerplatte (31) auf, die mittels anisotroper Ätztechnik mikromechanisch strukturiert ist. In eine Nut (30) werden die Komponenten des Isolators (10) eingebracht. Die Komponenten des Isolators (10) weisen zumindest eine ebene Randfläche auf, mit der sie an einer anisotrop geätzten Wand der Nut (3) anliegen.

Fig. 3

EP 0 701 155 A2

## Beschreibung

Die Erfindung betrifft ein Lasermodul insbesondere zur Ankopplung an einen Lichtwellenleiter mit einem Halbleiterlaser in einem Gehäuse und mit einem Isolator.

Solche Lasermodule sind aus der EP 02 59 888 B1 und der DE 42 32 327 A1 bekannt. In beiden Schriften wird ein Laser auf einem Chipträger beschrieben, dessen Licht mit einer ersten Linse kollimiert wird und die Gehäusewand über ein schräg gestelltes Planfenster durchdringt. Das Gehäuse wird dabei mit dem Planfenster hermetisch dicht abgeschlossen. Außerhalb des Gehäuses wird das Licht mit einer zweiten Linse auf die Stirnfläche einer Lichtleitfaser fokussiert. In der zweiten Schrift wird zusätzlich noch ein Isolator beschrieben, der außerhalb des hermetisch eingeschlossenen Volumens in einem Stutzen sitzt, der in das Gehäuse hineinragt und an seinem Ende das Fenster trägt.

Aus der DE 44 22 322.6 ist ein Lasermodul mit einer Silizium-Trägerplatte bekannt, die mittels anisotroper Ätztechnik mikromechanisch strukturiert ist. In eine erste Nut werden eine erste Linse und ein Isolator eingebracht. In einer zweiten Nut befindet sich eine Monitordiode. Der Halbleiterlaser ist auf dem Steg zwischen den Nuten montiert.

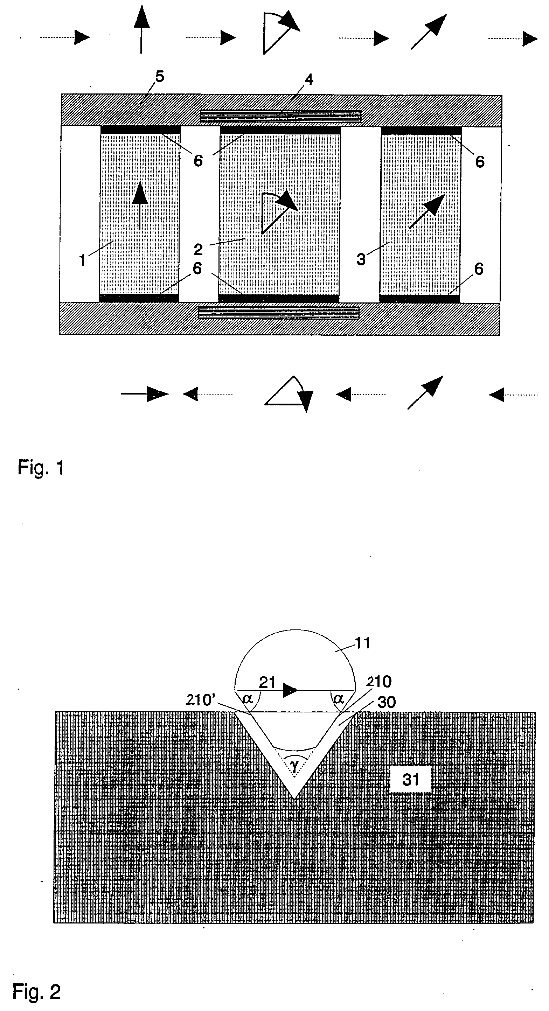

Soll eine Laserdiode für sehr hohe Übertragungsfrequenzen bzw. Bitraten eingesetzt werden, so ist es erforderlich, rückreflektierte Strahlung von der Laserdiode fernzuhalten. Die Rückreflexe können sowohl an der zur optischen Ankopplung zwischen Laserdiode und Faser erforderlichen Koppeloptik als auch auf der Faserstrecke selbst (Steckkontakte, Spleiße) entstehen. Die Reflexe an der Koppeloptik werden nach dem Stand der Technik dadurch vermieden, daß die optischen Flächen mit einer Antireflexionsbeschichtung vergütet werden und/oder schräg zum Strahlengang eingebaut werden. Die Rückreflexe aus der Faserstrecke können durch diese Maßnahmen nicht beseitigt werden. Nach dem Stand der Technik wird hierzu ein optischer Isolator eingesetzt. Ein solcher optischer Isolator besteht aus einem ersten Polarisator, einem optischen Kristall mit Faraday-Effekt in einem statischen Magnetfeld, der die Polarisationsebene des Lichtes um 45° dreht, und aus einem zweiten Polarisator, dessen Polarisationsrichtung gegenüber der des ersten Polarisators um 45° verdreht ist. In der Durchlaßrichtung trifft das im ersten Polarisator linear polarisierte Licht nach Drehung um 45° mit seiner Polarisationsebene parallel zur Polarisationsrichtung des zweiten Polarisators auf diesen und wird deshalb nahezu nicht geschwächt. In der entgegengesetzten Richtung, der Sperrichtung, bewirkt die Drehung um 45°, daß das vom zweiten Polarisator linear polarisierte Licht den ersten Polarisator um 90° zu dessen Polarisationsrichtung verdreht trifft und deshalb gesperrt wird. In der Figur 1 sind die Lichtwege (gestrichelte Pfeile) und die Polarisationsrichtungen bzw. -drehungen (durchgezogene Pfeile, wobei die Polarisationswinkel jeweils in die Zeichenebene umgeklappt wurden) für die Durchgangsrichtung (obere Pfeilreihe) und Sperrichtung (untere Pfeilreihe) eingezeichnet. Um eine für den Gebrauch wichtige geringe Durchgangs- und hohe Sperrdämpfung zu erreichen, ist neben einer hohen Qualität der Polarisatoren und des Faraday-Rotators eine sehr exakte azimutale Ausrichtung dieser Bauteile zueinander erforderlich. Um einen Isolator vor Umwelteinflüssen zu schützen, ist es nach dem Stand der Technik erforderlich, alle optischen Komponenten des Isolators gemeinsam in ein zylindrisches Metallgehäuse hermetisch dicht zu verschließen. Die Baugröße des gesamten Isolators muß dabei so klein sein, daß er in den für die Laserankopplung erforderlichen mikrooptischen Strahlengang hineinpaßt. Nach dem Stand der Technik ist hierfür ein Außendurchmesser von 3 mm und eine Länge von 4 mm üblich. Bei der Montage des fertigen Isolators in einem Lasersendemodul muß eine exakte azimutale Ausrichtung des Isolators zur Polarisationsebene der Laserdiode durchgeführt werden. Dies bedeutet einen zusätzlichen Justageschritt bei der Lasermontage.

Aufgabe der vorliegenden Erfindung ist es, ein Lasersendemodul anzugeben, das besonders einfach aufgebaut ist und einen leicht zu montierenden Isolator aufweist.

Die Aufgabe wird durch eine Anordnung mit den Merkmalen des Patentanspruches 1 gelöst. Vorteilhafte Weiterbildungen sind in den Unteransprüchen angegeben.

Die Erfindung wird anhand der Abbildungen erläutert. Die Figur 1 zeigt in einem Längsschnitt einen Isolator gemäß dem Stand der Technik mit einem ersten Polarisator 1, einem Faraday-Rotator 2 mit einem ringförmigen Permanentmagnet 4 und einem zweiten Polarisator 3. Diese Komponenten sind gemeinsam in einem zylindrischen Gehäuse 5 hermetisch dicht über Lötverbindungen 6 eingebaut. Bei dieser Art der Montage ist es sehr kostenintensiv, die einzelnen Komponenten mit hoher Präzision azimutal zueinander auszurichten und hermetisch dicht einzulöten.

Bei einem Einsatz des Isolators vor einer Laserdiode, die ohnehin in einem hermetisch dichten Gehäuse montiert werden muß, ist eine hermetisch dichte Verkapselung der Einzelkomponenten des Isolators dann nicht erforderlich, wenn sie im gleichen hermetisch dichten Gehäuse wie der Laser untergebracht werden. Die Komponenten des Isolators können viel einfacher und kostengünstiger mit einem Klebstoff fixiert werden. Um die Komponenten des Isolators azimutal mit hoher Präzision zueinander auszurichten wird vorgeschlagen, daß die Komponenten mit mindestens einer ebenen Fläche 210 am Rand versehen werden. Diese ebene Fläche 210 hat eine feste azimutale Winkelbeziehung zu der erforderlichen azimutalen Winkellage der jeweiligen Isolator-Komponente. In Figur 2 ist beispielsweise ein erster Polarisator 11 mit seiner Polarisationsebene 21 in waagerechter Richtung dargestellt. Der Polarisator hat zwei ebene Randflächen 210 und 210', die einen Winkel von

$$\alpha = \arctan (\sqrt{2}) = 54,74°$$

mit der Polarisationsrichtung des Polarisators 11 einschließen, so daß der Winkel γ zwischen den beiden Flächen 210 und 210'

$$\gamma = 180° - 2 \cdot a = 70,53°$$

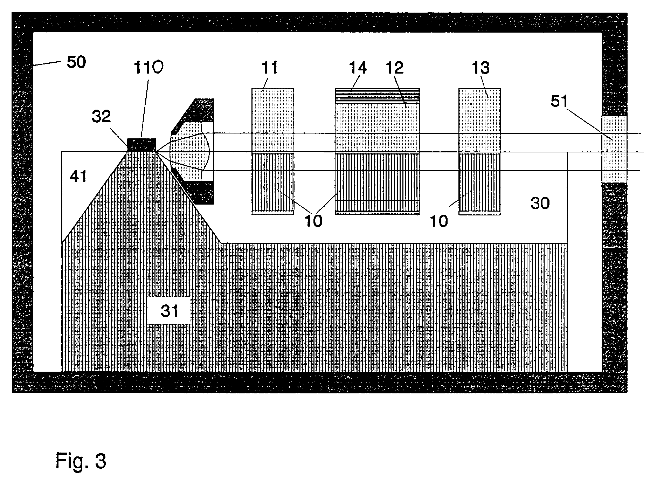

beträgt. Diese Winkel entstehen, wenn in {100}-orientiertem einkristallinem Silizium eine V-Nut in ⟨110⟩-Richtung anisotrop geätzt wird. In Figur 3 ist eine V-Nut 30 in einem Siliziumsubstrat 31 dargestellt. Der Polarisator 11 wird nun in diese V-Nut eingelegt, wobei eine sehr exakte azimutale Winkelausrichtung erreicht wird. Auf gleiche Weise werden die anderen Isolator-Komponenten, der Faraday-Rotator 12 und der zweite Polarisator 13 montiert, die jeweils ebenfalls mit ebenen Randflächen 210 und 210' versehen sind, wobei diese Randflächen jeweils mit der erforderlichen azimutalen Lage, die für die entsprechende Komponente erforderlich ist, ausgerichtet sind. Der Faraday-Rotator ist dabei im Randbereich mit einem Permanentmagneten 14 versehen.

Weiter ist es ein Vorteil der erfindungsgemäßen Lösung, daß nicht nur, wie schon gesagt, auf die gegenseitige azimutale Justage der Einzelkomponenten zueinander bei der Herstellung des Isolators verzichtet werden kann, sondern daß ebenso eine nach dem Stand der Technik erforderliche azimutale Justage des gesamten Isolators zur Polarisationsebene des Lasers entfällt.

Halbleiterlaser senden bereits eine linear polarisierte Lichtstrahlung aus, deren Polarisationsebene parallel zur aktiven Fläche liegt. Wird nun der Halbleiterlaser 110 direkt auf die Oberfläche 32 oder parallel hierzu montiert, so liegt eine feste Winkelbeziehung zwischen der Polarisationsebene des Laserlichtes und der Ausrichtung der optischen Komponenten des Isolators vor. Eine azimutale Justage zwischen Laser-Polarisationsebene und Isolator, die nach dem Stand der Technik erforderlich ist, entfällt dadurch.

Weiterhin ist es sogar möglich, den ersten Polarisator 11 ganz wegzulassen. Für die Durchgangsrichtung ist er nicht erforderlich, da das Laserlicht ohnehin bereits linear polarisiert ist. Auch für die Sperrichtung ist der Polarisator 11 nicht erforderlich. Dies liegt daran, daß in Sperrichtung aus dem Faraday-Rotator nur Licht auf den Laser fällt, dessen Polarisationsebene senkrecht zur Polarisationsebene des Lasers ist. Durch so polarisiertes Licht wird der Laser aber nicht gestört.

In der gleichen V-Nut 30 können neben dem Isolator noch weitere optische Komponenten, die für die optische Strahlführung erforderlich sind, justagefrei montiert werden. So ist beispielsweise zwischen dem Laser und dem Isolator eine Kollimierungslinse angebracht. Ebenso kann der Isolator bei erhöhten Anforderungen an die Sperrdämpfung durch Hinzufügen eines weiteren Faraday-Rotators und Polarisators zu einem zweistufigen Isolator auf einfache Weise erweitert werden. Auf der rückwärtigen Seite des Lasers kann eine Nut 41 ebenfalls anisotrop geätzt werden, um eine Monitordiode (hier nicht gezeichnet) aufzunehmen. Um alle Komponenten vor Umwelteinflüssen hermetisch dicht zu schützen, wird das Siliziumsubstrat mit den elektronischen, elektrooptischen und optischen Bauteilen in ein Gehäuse 50 eingebaut, das an einer Außenfläche ein Fenster 51 hat, durch welches der Strahl austritt. Im Außenraum wird der Strahl mit einer Fokussierungslinse, die auch das Fenster 50 ersetzen kann, fokussiert und in eine Lichtleitfaser eingekoppelt (hier nicht gezeigt). Um direkte Rückreflexionen an den Grenzflächen der optischen Komponenten zu vermeiden, können diese, wie nach dem Stand der Technik bekannt, mit Antireflexionsschichten versehen werden und/oder zum Strahlengang geneigt werden.

## Patentansprüche

1. Lasermodul, insbesondere zur Einkopplung von Licht in einen Lichtwellenleiter, mit folgenden Merkmalen:

    a) es ist eine Silizium-Trägerplatte (31) vorgesehen, die mittels anisotroper Ätztechnik mikromechanisch strukturiert ist und zumindest eine langgesteckte Nut (30) aufweist,

    b) auf der Silizium-Trägerplatte (31) oder parallel zu deren Oberfläche (32), ist am Ende der Nut (30) ein Halbleiterlaser (110) derart montiert, daß er Licht parallel zur Längsachse der Nut (30) aussendet,

    c) es ist ein Isolator (10) vorgesehen,

    c1) zumindest die in Bezug auf die Durchlaßeigenschaften nicht rotationssymmetrischen Komponenten (11,12,13,) des Isolators (10) weisen zumindest eine ebene Randfläche (210,210') auf, die eine definierte Lage zu den jeweiligen Durchlaßeigenschaften der Komponente hat,

    c2) die einzelnen Komponenten (11,12,13) des Isolators (10) sind in die Nut (30) eingelegt, derart, daß die ebene Randfläche (210,210') auf einer anisotrop geätzten Wand der Nut (30) liegt,

    d) es ist ein abgeschlossenes Gehäuse (50) vorgesehen, in dem die Silizium-Trägerplatte (31) mit dem Halbleiterlaser (110) und dem Isolator (10) untergebracht ist.

2. Lasermodul nach Anspruch 1, dadurch gekennzeichnet, daß sich der Isolator (10) aus einem ersten Polarisator (11) einem Faraday-Rotator (12) und einem zweiten zu dem ersten Polarisator (11) gedrehten Polarisator (13) zusammensetzt.

3. Lasermodul nach Anspruch 1, dadurch gekennzeichnet, daß sich der Isolator (10) aus einem Faraday-Rotator (12) und einem Polarisator (13) zusammensetzt, wobei der Polarisator (13) auf der vom Halbleiterlaser abgewandten Seite des Faraday-Rotators (12) angeordnet ist und Licht hindurchläßt dessen Polarisationsebene um den Drehwinkel des Faraday-Rotators (12) gegen die Polarisationsebene des Lichtes aus dem Halbleiterlaser gedreht ist.

4. Lasermodul nach einem der Ansprüche 1 bis 3, dadurch gekennzeichnet, daß die Nut (30) eine V-Nut ist.

5. Lasermodul nach Anspruch 4, dadurch gekennzeichnet, daß alle Komponenten des Isolators (10) zwei ebene Randflächen aufweisen, mit denen man sie in die V-Nut (30) einlegen kann.

6. Lasermodul nach einem der Ansprüche 1 bis 4, dadurch gekennzeichnet, daß weitere optische Komponenten in die V-Nut (30) eingelegt sind.

Fig. 1

Fig. 2

Fig. 3